# EUROPEAN PATENT APPLICATION

(11) **EP 4 481 805 A1**
(43) Date of publication of application: **25.12.2024**
(21) Application number: 24180053.1
(22) Date of filing: 04.06.2024
(51) Int. Cl.: H01L 23/31, H01L 23/00, H01L 25/065, H01L 21/56

(54) **CHIP PACKAGE STRUCTURE AND ELECTRONIC DEVICE**

(30) Priority: 20.06.2023 CN 202310740162
(71) Applicant: Huawei Technologies Co., Ltd., Shenzhen, Guangdong 518129 (CN)
(72) Inventor: ZHAO, Ning, Shenzhen, 518129 (CN); GU, Mingyue, Shenzhen, 518129 (CN); CHIEN, Wu Chun, Shenzhen, 518129 (CN); HU, Hengqian, Shenzhen, 518129 (CN); ZHANG, Chi, Shenzhen, 518129 (CN); LUO, Yijing, Shenzhen, 518129 (CN); LIU, Yang, Shenzhen, 518129 (CN)
(74) Representative: Gill Jennings & Every LLP

(57) **Abstract**

This application provides a chip package structure and an electronic device. The chip package structure includes a chip and a package portion. The package portion is disposed around the chip and encloses a peripheral side surface of the chip. The package portion is provided with at least one hole. The structure can alleviate a problem of delamination between the package portion and the chip or cracking of the package portion caused by a large stress generated between the package portion and the chip due to a temperature change in the chip package structure.

## Description

### TECHNICAL FIELD

This application relates to the field of chip packaging, and specifically, to a chip package structure and an electronic device.

### BACKGROUND

In the field of chip packaging, to protect a chip, the chip usually needs to be packaged. When the chip is packaged, a peripheral side surface of the chip usually needs to be coated with organic resin to form a package portion of the chip. The package portion is connected to a side surface of the chip in an enclosed manner, to enclose and protect the chip. In an actual use process, a part that is of the package portion and that is close to the chip is easy to crack, resulting in a failure of the package portion in enclosing the chip. Through analysis, the inventor of this application finds that, in a chip package structure, a coefficient of thermal expansion (coefficient of thermal expansion, CTE) of the package portion is usually different from that of the chip. The coefficient of thermal expansion of the package portion formed by the organic resin is far greater than the coefficient of thermal expansion of the chip formed by a die. During a cyclic change of temperatures, because the CTEs of the package portion and the chip do not match, the package portion expands more than the chip at a high temperature, and the package portion pulls an interface between the package portion and the chip, causing separation between the package portion and the chip. The package portion shrinks more than the chip at a low temperature, and the package portion separated from the chip bears an extrusion force exerted by the chip in this case, causing the package portion to crack and reducing reliability of chip protection.

### SUMMARY

This application provides a chip package structure and an electronic device, to resolve a problem that reliability of protecting a chip by a package portion is reduced because the package portion on the existing chip is easy to delaminate and crack during use.

According to a first aspect, this application provides a chip package structure. The chip package structure includes a chip and a package portion. The package portion is disposed around the chip and encloses a peripheral side surface of the chip. The package portion is provided with at least one hole.

In the chip package structure in this application, the package portion is disposed on the peripheral side surface of the chip and encloses the peripheral side surface, so that the chip can be protected from water, vapor, and mechanical damage. The package portion is provided with one or more holes. The at least one hole is provided in the package portion, so that when the package portion expands or shrinks in a high or low temperature environment, the hole may be used as internal release space of the package portion for deformation. When the package portion expands in the high temperature environment, the hole may block a pulling force exerted by the package portion on a connection interface between the package portion and the chip due to a high CTE of the package portion, so that a good anti-separation effect is achieved for the package portion and the chip. When the package portion shrinks in the low temperature environment, the hole may release an acting force exerted by the chip on the package portion, to prevent the package portion from cracking under the acting force of the chip.

In a possible implementation, an axial direction of each hole extends in a height direction of the peripheral side surface of the chip. For example, the axial direction of the hole is parallel to the height direction of the peripheral side surface, or is at a specific angle with the height direction of the peripheral side surface. The hole extends in the height direction of the peripheral side surface of the chip, so that the package portion has space for stress release in the height direction of the peripheral side surface of the chip.

In a possible implementation, a part or all of the at least one hole is provided near at least one geometric bump position on the peripheral side surface of the chip. The geometric bump position includes but is not limited to a turning position on the peripheral side surface of the chip. A geometric bump of the chip is usually a high stress concentration point. Therefore, providing the hole close to the geometric bump position of the chip may reduce stress concentration, thereby preventing the package portion from cracking due to pressure, and improving structural stability of the package portion. The geometric bump of the chip may be, for example, a turning point of the chip. When an outline of the chip is a cuboid, geometric bumps are, for example, four corners of an upper surface of the cuboid structure. When the chip is in another irregular shape, the geometric bump may be a turning part of the another irregular shape.

In a possible implementation, one or more holes may be provided near each geometric bump position. When a plurality of holes are provided near one geometric bump position, a stress at the geometric bump position can be well released, so that stability of the package portion is better.

In a possible implementation, it is assumed that a thickness of the package portion is L. When the axial direction of the hole extends in the height direction of the peripheral side surface of the chip, a minimum distance D between a hole wall of the hole and the peripheral side surface of the chip satisfies 20 µm≤D≤0.9*L. The minimum distance D between the hole wall of the hole and the peripheral side surface of the chip is greater than or equal to 20 µm, so that a specific distance is reserved between the hole wall of the hole and the peripheral side surface of the chip, to avoid impact of a hole setting on hermetic packaging of the chip. The minimum distance D between the hole wall of the hole and the peripheral side surface of the chip satisfies 20 µm≤D≤0.9*L. This can avoid a problem that the package portion easily cracks at the hole due to an excessively small distance between the hole wall of the hole and the peripheral side surface of the chip when a pulling force is generated between the package portion and the chip due to a high CTE of the package portion. Alternatively, this can avoid a problem that it is not conducive to stress release between the package portion and the chip due to an excessively large distance between the hole wall of the hole and the peripheral side surface of the chip. The minimum distance between the hole wall of the hole and the peripheral side surface of the chip satisfies 20 µm≤D≤0.9*L, so that stability of the package structure and reliability of the chip can be improved on the basis of meeting mechanical strength and chip enclosure performance. For example, the minimum distance D between the hole wall of the hole and the peripheral side surface of the chip may satisfy 40 µm≤D≤0.8L. Through the hole of the foregoing size, the package portion can better implement high-strength and high-reliability enclosure of the chip on the basis of implementing stress dispersion.

In a possible implementation, a maximum hole diameter d of the hole satisfies 0.1L≤d≤0.9*L.

In a possible implementation, the at least one hole may be provided on the peripheral side surface of the chip in a distributed manner. Providing a plurality of holes in the distributed manner can evenly increase stress release points in the package portion, thereby further improving a protection effect for the chip.

In an optional implementation, the hole may be a blind hole or a via.

In an optional implementation, the hole may be further filled with a flexible material. Filling the hole with the flexible material is conducive to protecting the hole wall and a hole bottom of the hole.

In an optional implementation, the package portion may be made of a plastic packaging material. The plastic packaging material has features such as scalability and flexibility, so that the chip can be better protected.

According to a second aspect, this application further provides an electronic device. The electronic device includes the chip package structure in this application.

The chip package structure in this application may be used to package a network chip, a routing chip, or the like. Correspondingly, the electronic device in this application may include but is not limited to a device such as a network device, a base station device, or a router.

For technical effects that can be achieved in the second aspect, refer to corresponding effect descriptions in the first aspect. Details are not described herein again.

### BRIEF DESCRIPTION OF DRAWINGS

FIG. 1 is a diagram of a chip package structure according to an embodiment;
FIG. 2 is a diagram of a chip package structure according to an embodiment;
FIG. 3 is a diagram of a chip package structure according to an embodiment;
FIG. 4 is another diagram of a chip package structure according to an embodiment;
FIG. 5 is a schematic top view of a structure of a package portion and a chip according to an embodiment;
FIG. 6 is a diagram of a position of a hole according to an embodiment;
FIG. 7 is a diagram of a position of a hole according to an embodiment;
FIG. 8 is a diagram of a longitudinal structure of a hole according to an embodiment;
FIG. 9 is a diagram of a longitudinal structure of a hole according to an embodiment; and
FIG. 10 is a diagram of a longitudinal structure of a hole according to an embodiment.

### Reference numerals:

11-substrate; 21-chip; 31-package portion; 311-hole; 312-flexible material; 41-silicon bridge; 411-conductive column; 42-redistribution layer; and 51-sealant layer.

### DESCRIPTION OF EMBODIMENTS

To make objectives, the technical solutions, and advantages of this application clearer, the following further describes this application in detail with reference to the accompanying drawings.

Terms used in the following embodiments are merely intended to describe specific embodiments, but are not intended to limit this application. Terms "one", "a", "the foregoing", "the", and "the one" of singular forms used in this specification and the appended claims of this application are also intended to include plural forms, for example, "one or more", unless otherwise specified in the context clearly. The terms "include", "comprise", "have", and their variants in this specification all mean "include but are not limited to", unless otherwise specifically emphasized in another manner.

2.5D packaging refers to packaging of a chip and a substrate by using a medium layer, a silicon bridge, a high-density redistribution layer (re-distributed layer, RDL), or any interconnection medium with an input/output (input/output, I/O) density far higher than that of an ABF substrate. 3D packaging refers to multi-chip and multidimensional packaging. In the 2.5D or 3D packaging, a package portion is made of an organic resin material, so that a chip can be effectively protected.

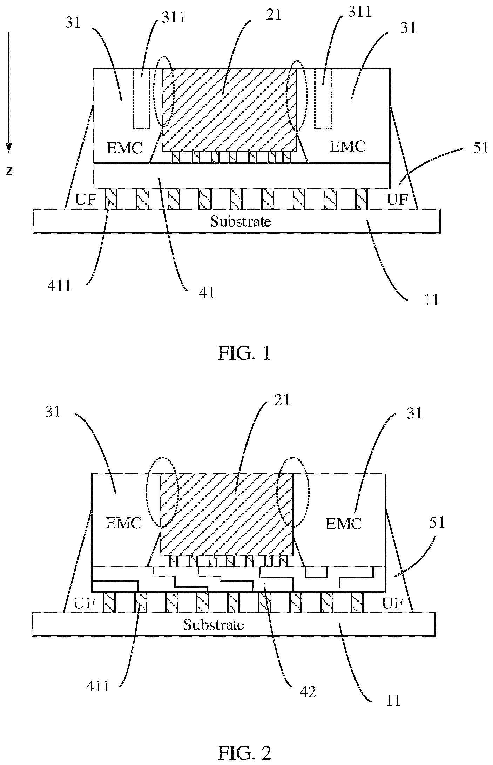

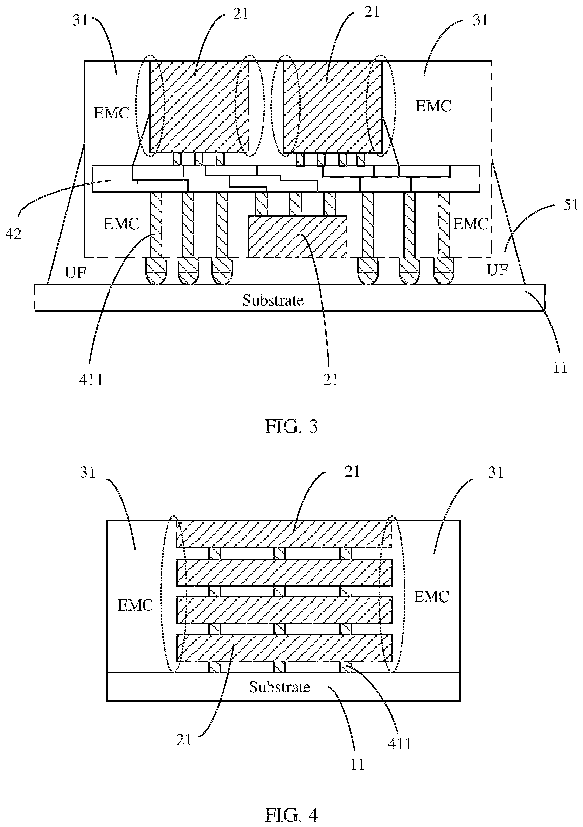

FIG. 1 is a diagram of a chip package structure according to an embodiment. FIG. 2 is a diagram of a chip package structure according to an embodiment. FIG. 3 is a diagram of a chip package structure according to an embodiment. As shown in FIG. 1 to FIG. 3, the chip package structure in embodiments of this application includes a substrate 11, a chip 21, and a package portion 31. The substrate 11 may be configured to carry the chip 21. The substrate 11 may be formed by, but not limited to, organic polymer resin, and may be embedded with a metal wire, so that the substrate 11 can carry one or more chips and be electrically connected to the one or more chips. The substrate 11 and the chip 21 may be electrically connected through a conductive column 411 and a silicon bridge 41 (as shown in FIG. 1), may be electrically connected through the conductive column 411 and a redistribution layer 42 (as shown in FIG. 2), or may be electrically connected through a combination of the redistribution layer 42, the conductive column 411, and the chip 21 (as shown in FIG. 3).

As shown in FIG. 1 to FIG. 3, in the chip package structure, one package structure may be used to package one chip 21, or may be used to package a plurality of chips 21. The chip 21 may be a die that is not packaged by using a packaging material, or may be a die that is packaged by using a packaging material.

FIG. 4 is another diagram of a chip package structure according to an embodiment. As shown in FIG. 4, a plurality of chips 21 may be packaged in a same package structure. The plurality of chips 21 may be stacked in a plurality of layers, to implement 3D three-dimensional packaging.

As shown in FIG. 1 to FIG. 4, in an embodiment, the package portion 31 may be disposed around the chip 21, and is connected to a peripheral side surface of the chip 21 in an enclosed manner. This may also be referred to as enclosing the peripheral side surface of the chip 21. In this way, a function of protecting the chip 21 by using the package portion 31 is implemented. A material of the package portion 31 may be polymer organic resin, for example, an epoxy molding compound (epoxy molding compound, EMC). A connection position between the chip 21 and the package portion 31 is shown by a dashed line in FIG. 1 to FIG. 4. Above the substrate 11 and below the chip 21, that is, between the substrate 11 and the chip 21, connection lines other than connection lines in the silicon bridge 41 and the redistribution layer 42 may be filled and sealed by using a packaging adhesive, and a sealant layer 51 may be formed on a periphery of the package portion 31. The sealant layer 51 may be a thermosetting resin material (underfill, UF).

In the structures shown in FIG. 1 to FIG. 4, a coefficient of thermal expansion of the substrate 11 is usually large. When the chip package structure is subject to high and low temperature environments, the substrate 11 expands and shrinks greatly. Because the sealant layer 51 is bonded to the substrate 11, when the substrate 11 expands greatly due to thermal expansion, the substrate 11 drives, through the sealant layer 51, the package portion 31 to move in a direction away from the chip 21. At the same time, thermal expansion of the package portion 31 occurs. As a result, the package portion 31 generates a large pulling force on an interface layer between the package portion 31 and the chip 21, causing the package portion 31 and the chip 21 to delaminate. In addition, when the substrate 11 shrinks in the low temperature environment, the substrate 11 drives, through the sealant layer 51, the package portion 31 to move in a direction toward the chip 21, and the package portion 31 also moves in the direction toward the chip 21 when the package portion 31 shrinks. Because a coefficient of thermal expansion of the chip 21 is low, the chip 21 basically does not deform. Therefore, when the package portion 31 shrinks greatly in the direction toward the chip 21, the chip 21 exerts an extrusion force on the package portion 31. After the package portion 31 and the chip 21 are separated or partially separated on a connection interface in the high temperature environment, the package portion 31 is very easily punctured by the chip 21 in the low temperature environment, affecting reliability of packaging the chip 21.

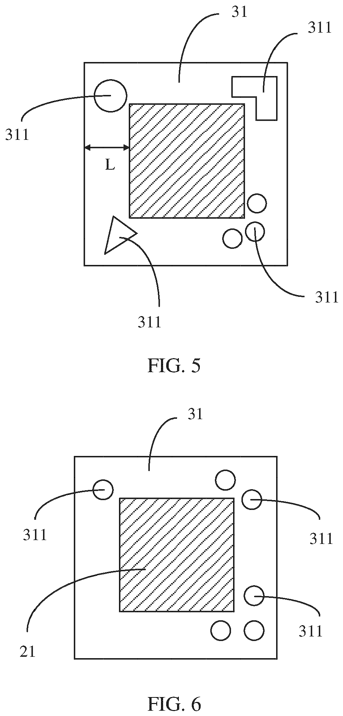

FIG. 5 is a schematic top view of a structure of a package portion and a chip according to an embodiment of this application. To resolve a problem that the package portion 31 is easily separated from the chip 21, or the package portion 31 cracks, as shown in FIG. 5, in the chip package structure in embodiments of this application, the package portion 31 may be provided with one or more holes 311. Further refer to FIG. 1. An axial direction of the hole 311 may extend in a height direction of the peripheral side surface of the chip 21, for example, in a z direction shown in FIG. 1. In addition, the axial direction of the hole 311 may be inclined to the height direction of the peripheral side surface. For example, a specific angle may be included between the axial direction of the hole 311 and the height direction of the peripheral side surface of the chip 21. In addition, the axial direction of the hole 311 may be perpendicular to the height direction of the peripheral side surface of the chip 21, or may form a specific included angle with a direction perpendicular to the height direction of the peripheral side surface of the chip 21. The hole 311 is used to release an interface stress caused by different coefficients of thermal expansion of the chip 21 and the package portion 31, to avoid a problem that the package portion 31 is easily separated from the chip 21 in the high temperature environment, or a problem that the package portion 31 cracks in the low temperature environment, and avoid affecting an enclosure effect of the package portion 31 on the chip 21. An opening method of the hole 311 includes but is not limited to a laser opening manner (for example, a manner of ultraviolet laser opening or a manner of carbon dioxide laser opening), and a plurality of manners such as mechanical opening/cutting opening may also be used.

Still refer to FIG. 5. In an embodiment, as shown in FIG. 1, if a shape of an orthographic projection of the chip 21 on the substrate 11 is a rectangle, a shape of an orthographic projection of the package portion 31 on the substrate 11 may be a rectangle annular structure. The structure shown in FIG. 5 is merely an example for description. A shape of the chip 21 may alternatively be a cube, a cylinder, or another shape. This is not limited in this application. A shape of the package portion 31 may be a corresponding shape formed by the peripheral side surface enclosing the chip 21. Providing the hole 311 in the package portion 31 can release a pulling force, a shrinking force, and an extrusion force that are borne by the package portion 31. Therefore, a problem of delamination between the package portion 31 and the chip 21 can be avoided, and damage and cracking of the package portion 31 caused by an excessively concentrated stress on the package portion 31 can also be avoided. There may be a plurality of holes 311 provided in the package portion 31. When the plurality of holes 311 are provided in the package portion 31, the holes 311 may be provided in a distributed manner on an unfolded area of the package portion 31. A shape of a cross-section of the hole 311 may be a circular hole, a square hole, an L-shaped hole, a triangular hole, or a hole 311 in another irregular shape, for example, a triangular hole, a circular hole, and an L-shaped hole shown in FIG. 5. This is not limited in this application. In addition, sizes of holes in a same shape in a radial direction may be different or may be the same. This is not limited in this application.

Still refer to FIG. 5. A hole may be provided at a part that is of a geometric bump position of the chip 21 and that corresponds to the package portion 31 for enclosure. A geometric bump is usually a turning part in a peripheral side surface structure of the chip 21, that is, usually a part in which a bump exists on the chip 21. As shown in FIG. 5, when a shape of a cross-sectional outline of the chip 21 in a direction parallel to the substrate 11 is a rectangle, geometric bumps of the chip 21 may be corners of the chip or four edge parts on the peripheral side surface of the chip 21. Each edge part is an overlapping area of two adjacent side surfaces of the chip 21. Usually, a stress is easily concentrated at the geometric bump position of the chip 21, and a high stress area is formed. The package portion 31 is easier to crack at the geometric bump position. Therefore, providing the hole 311 on the package portion 31 near the geometric bump of the chip 21 can better release the stress at the geometric bump position of the chip 21, the package portion 31 is more stable, and an effect of packaging the chip 21 is better. For example, one hole 311 may be provided at each geometric bump position of the chip 21, or a plurality of holes 311 may be provided. Usually, providing a plurality of holes 311 can better release a stress at a corresponding geometric bump position of the chip 21.

FIG. 6 is a diagram of a position of a hole according to an embodiment. As shown in FIG. 6, for example, one hole 311, two holes 311, or three or more holes 311 may be provided at each geometric bump position of the chip 21, to better implement stress dispersion. A quantity of holes 311 provided at each geometric bump position is not specifically limited in this embodiment of this application.

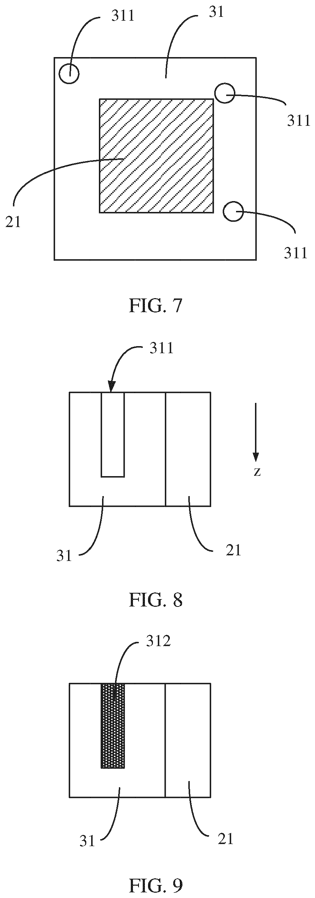

FIG. 7 is another diagram of a position of a hole according to an embodiment. As shown in FIG. 7, a position of the hole 311 may be close to an edge of the chip 21, or may be away from an edge of the chip 21. This is not specifically limited herein.

Still refer to FIG. 5. It is assumed that a thickness of the package portion 31 is denoted as L. When a thickness direction of the package portion 31 is perpendicular to the height direction of the peripheral side surface of the chip 21, the axial direction of the hole 311 may be set to extend in the height direction of the peripheral side surface of the chip 21 when a hole is provided in the package portion 31, so that a minimum distance D between a hole wall of the hole 311 and the peripheral side surface of the chip 21 may be set to satisfy 20 µm≤D≤0.9*L, for example, 40 µm≤D≤0.8L. If the minimum distance between the hole wall of the hole 311 and the peripheral side surface of the chip 21 is excessively small, structural strength of the package portion 31 is reduced. This is not conducive to implementing a function of protecting the chip 21 by the package portion 31. If the minimum distance between the hole wall of the hole 311 and the peripheral side surface of the chip 21 is excessively large, it is not conducive to stress release. Therefore, in this application, the distance between the hole wall of the hole 311 and the peripheral side surface of the chip 21 is limited to a range of 20 µm≤D≤0.9*L, and in particular, is limited to a range of 40 µm≤D≤0.8L, so that a stress release effect can be improved while the structural strength of the package portion 31 is effectively ensured, thereby improving reliability of packaging the chip 21. In addition, a maximum hole diameter d of the hole satisfies 0.1L≤d≤0.9*L. If the hole diameter of the hole is excessively small, it is not conducive to stress release. If the hole diameter of the hole is excessively large, it is not conducive to improving overall structural strength of the package portion 31.

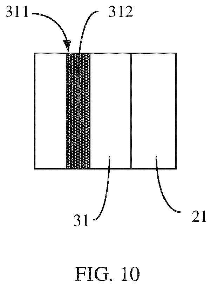

FIG. 8 is a diagram of a longitudinal structure of a hole according to an embodiment. FIG. 9 is another diagram of a longitudinal structure of a hole according to an embodiment. FIG. 10 is still another diagram of a longitudinal structure of a hole according to an embodiment. As shown in FIG. 8, the hole 311 may be a blind hole. As shown in FIG. 9, the hole 311 is a blind hole, and the hole may be further filled with a flexible material 312. Filling the hole with the flexible material 312 can protect the hole wall and a hole bottom of the hole 311. It may be understood that, when the hole 311 is a blind hole, because the blind hole is not connected to another component, for example, the substrate 11, at the bottom of the package portion 31, the hole 311 of a blind hole structure may not be filled with the flexible material 312. As shown in FIG. 10, the hole 311 is a via. Because the package portion 31 may be connected to the substrate 11 at the bottom, to implement a packaging effect, the hole 311 of a via structure may be filled with the flexible material 312, to better protect the hole wall and a hole bottom of the hole 311.

It is verified through experiments that, after the hole 311 is provided in the package portion 31, a significant alleviation effect is achieved for the high stress area at the interface between the chip 21 and the package portion 31. The via can reduce a high stress to 1/3 of an original stress, and the blind hole can also reduce the high stress to 1/2 to 1/3 of the original stress.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip package structure, comprising a chip and a package portion, wherein the package portion is disposed around the chip and encloses a peripheral side surface of the chip, and the package portion is provided with at least one hole.

2. The chip package structure according to claim 1, wherein an axial direction of the hole extends in a height direction of the peripheral side surface of the chip.

3. The chip package structure according to claim 1 or 2, wherein a part or all of the at least one hole is provided near at least one geometric bump position on the peripheral side surface of the chip, and the geometric bump position comprises a turning position on the peripheral side surface of the chip.

4. The chip package structure according to claim 3, wherein one or more holes are provided near each geometric bump position.

5. The chip package structure according to claim 2, wherein a thickness of the package portion is L, and a minimum distance D between a hole wall of the hole and the peripheral side surface of the chip satisfies 20 µm≤D≤0.9*L.

6. The chip package structure according to any one of claims 1 to 5, wherein the at least one hole is provided on the peripheral side surface of the chip in a distributed manner.

7. The chip package structure according to any one of claims 1 to 6, wherein the hole is a blind hole or a via.

8. The chip package structure according to any one of claims 1 to 7, wherein the hole is filled with a flexible material.

9. The chip package structure according to any one of claims 1 to 8, wherein the package portion is made of a plastic packaging material.

10. An electronic device, comprising the chip package structure according to any one of claims 1 to 9.
